Europäisches Patentamt

European Patent Office

Office européen des brevets

(19)

(11) Veröffentlichungsnummer: **0 155 386**
A1

(12) **EUROPÄISCHE PATENTANMELDUNG**

(21) Anmeldenummer: **84115319.0**

(22) Anmeldetag: **12.12.84**

(51) Int. Cl.⁴: **H 05 K 3/30**

(30) Priorität: **22.02.84 DE 3406434**

(43) Veröffentlichungstag der Anmeldung:
**25.09.85 Patentblatt 85/39**

(84) Benannte Vertragsstaaten:
**CH DE FR GB LI**

(71) Anmelder: **Siemens Aktiengesellschaft
Berlin und München Wittelsbacherplatz 2
D-8000 München 2(DE)**

(72) Erfinder: **Müller, Jochen, W.,Dr.,Dipl.-Ing.,
Kaltenbrunner Strasse 20
D-8000 München 70(DE)**

(54) **Verfahren zur Herstellung von vielpoligen Steckverbindern.**

(57) Das Bauelement, insbesondere vielpoliger Steckverbinder, besteht parallel zur Leiterplatte aus Bausteinen, die mit beispielsweise schwalbenschwanzförmigen Formschlußkonturen miteinander verzahnt sind. Der Steckverbinder läßt sich dadurch auf der Leiterplatte aus seinen Bausteinen zusammensetzen. Die Bausteine können dabei vorteilhaft optimal an die Greifwerkzeuge von automatischen Bestückungsautomaten angepaßt werden.

FIG 2

Croydon Printing Company Ltd.

0155386

Siemens Aktiengesellschaft
Berlin und München

Unser Zeichen
VPA 84 P 1142 E

Verfahren zur Herstellung von vielpoligen Steckverbindern

Die Erfindung bezieht sich auf ein Verfahren zur Herstellung von vielpoligen Steckverbindern, die einen leistenförmigen Isolierstoffkörper aufweisen, der im Rastermaß der Bohrungen einer Leiterplatte von metallischen Stiften durchdrungen ist, die auf der Leiterplattenseite des Isolierstoffkörpers in die Bohrungen der Leiterplatte eingesteckte Anschlußelemente bilden.

Bei der Bestückung von Leiterplatten mit Bauelementen ist man bestrebt, Bestückungsautomaten zu verwenden, um diese Tätigkeit möglichst weitgehend zu rationalisieren. Die Greifarme solcher Automaten können aber häufig nur für Bauelemente, die eine maximale Größe nicht überschreiten, verwendet werden. Vielpolige Steckverbinder müssen daher meist von Hand in eine Leiterplatte eingesetzt werden.

Aufgabe vorliegender Erfindung ist es daher, ein Verfahren der eingangs genannten Art so auszubilden, daß auch die Bestückung von Leiterplatten mit vielpoligen Steckverbindern durch Bestückungsautomaten vorgenommen werden kann, deren Greifarme an sich nur relativ kleine Bauelemente erfassen können.

Erfindungsgemäß ergibt sich die Lösung dieser Aufgabe dadurch, daß der Steckverbinder erst auf der Leiterplatte aus Bausteinen mit quer zur Längsrichtung des Steckverbinders aneinanderliegenden Wänden zusammengesetzt wird, indem ein im Querschnitt schwalbenschwanz-

Rt 1 Ktz / 07.11.1984

förmiger Ansatz, der jeweils auf der einen Seite eines Bausteines vorgesehen ist, in eine parallel zum Verlauf des Ansatzes gerichtete, dem Ansatz angepaßte Nut, die jeweils auf der anderen Seite eines Bausteins vorgesehen ist, eingeschoben wird und jeder Baustein mit zwei Anschlußelementen in zugeordnete Rasterbohrungen der Leiterplatte eingesteckt und durch die in den Rasterbohrungen fixierten Anschlußelemente an der Leiterplatte festgehalten wird.

Zwar ist schon aus der DE-OS 30 28 107 ein aus Kunststoff bestehendes Abstands- und Befestigungselement für elektrische Bauteile bekannt, das einen Körper aufweist, der mit Hilfe schwalbenschwanzförmig ineinandergreifender seitlicher Formschlußkonturen zu einem Verbundkörper aneinanderreihbar ist. Dieses bekannte Element dient jedoch nur zur erleichterten rastermäßigen Befestigung von ohnehin schon voneinander gesondert vorliegenden elektronischen Bauteilen, wie zum Beispiel von Leuchtdioden, an Leiterplatten.

Ein Ausführungsbeispiel der Erfindung wird nachfolgend anhand von zwei Figuren noch näher erläutert.

Dabei zeigen, in grob schematischer Darstellung und unter Weglassung aller nicht unbedingt zum Verständnis des Erfindungsgegenstandes erforderlichen Einzelheiten,

Fig. 1 in Seitenansicht, mit geschnitten dargestellter Leiterplatte, ein sich aus zwei Bausteinen zuammensetzendes Steckeverbinder-Bauelement und

**0155386**

Fig. 2 eine Ansicht von oben auf einen Stiftsteckverbinder mit geschnitten dargestelltem Kunststoffkörper, der sich aus vier Bausteinen zuammensetzt.

Im einzelnen ist den Figuren zu entnehmen, daß es sich bei dem Bauelement 1 um einen Stiftsteckverbinder handelt, der einen leistenförmigen Isolierstoffkörper 2 hat.

Der Isolierstoffkörper 2 des Bauelementes 1 wird im Rastermaß der Bohrungen 3 einer Leiterplatte 4 von metallischen Stiften 5 durchdrungen, die auf der Leiterplattenseite des Bauelementes 1 in die Bohrungen 3 der Leiterplatte 4 einsteckbare Anschlußelemente 6 bilden.

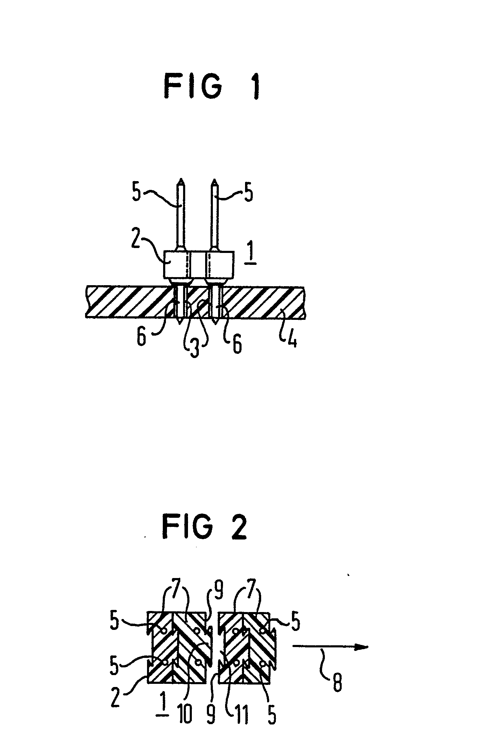

Wie insbesondere Fig. 2 zeigt, setzt sich der Steckverbinder, also das Bauelement 1, aus Bausteinen 7 zusammen.

Die einzelnen Bausteine 7 des Bauelementes 1 liegen dabei mit quer zur Längsrichtung 8 des Bauelementes 1 gerichteten Wänden 9 aneinander. Diese Wände 9 sind bei jedem Baustein 7 auf der einen Seite des Bausteines mit einem im Querschnitt schwalbenschwanzförmig ausgebildeten leistenförmigen Ansatz 10 versehen, der rechtwinkelig zur Leiterplatte 4 ausgerichtet ist. Auf der anderen Seite eines jeden Bausteines 7 ist die Wand 9 mit einer parallel zum Verlauf des Ansatzes gerichteten Nut 11 versehen, deren Querschnitt dem Querschnitt des Ansatzes angepaßt ist.

Wie Fig. 2 weiter zeigt, wird jeder Baustein 7 von zwei der Stifte 5 durchdrungen.

Jeder Baustein 7 kann unabhängig von den anderen Bausteinen 7 mit seinen Anschlußelementen 6 in zugeordnete Rasterbohrungen 3 der Leiterplatte 4 eingesteckt werden.

Die in den Bohrungen 3 fixierten, z.B. verlöteten Anschlußelemente 6 halten den Baustein an der Leiterplatte 4 fest. Parallel zur Leiterplatte 4 sind die Bausteine untereinander durch die schwalbenschwanzförmigen Formschlußkonturen 10, 11 verbunden. Auf diese Weise wird sichergestellt, daß insbesondere die beiden Endbausteine eines Steckverbinders nicht von den übrigen Bausteinen des Steckverbinders weggebogen werden können. Dadurch wird gewährleistet, daß die Stifte 5 des Steckverbinders, die auf der von der Leiterplatte 4 abgewandten Seite des Isolierstoffkörpers 2 z.B. mit einer Konaktfederleiste verbindbare Anschlußstifte bilden, im vorgesehenen Kontaktraster von der Leiterplatte 4 abstehen.

1 Patentanspruch

2 Figuren

0155386

## Patentanspruch

Verfahren zur Herstellung von vielpoligen Steckverbindern, die einen leistenförmigen Isolierstoffkörper aufweisen, der im Rastermaß der Bohrungen einer Leiterplatte von metallischen Stiften durchdrungen ist, die auf der Leiterplattenseite des Isolierstoffkörpers in die Bohrungen der Leiterplatte eingesteckte Anschlußelemente bilden,

d a d u r c h   g e k e n n z e i c h n e t ,
daß der Steckverbinder (1) erst auf der Leiterplatte (4) aus Bausteinen (7) mit quer zur Längsrichtung (8) des Steckverbinders (1) aneinanderliegenden Wänden (9) zusammengesetzt wird, indem ein im Querschnitt schwalbenschwanzförmiger Ansatz (10), der jeweils auf der einen Seite eines Bausteins (7) vorgesehen ist, in eine parallel zum Verlauf des Ansatzes (10) gerichtete, dem Ansatz angepaßte Nut (11), die jeweils auf der anderen Seite eines Bausteins (7) vorgesehen ist, eingeschoben wird und jeder Baustein (7) mit zwei Anschlußelementen (6) in zugeordnete Rasterbohrungen (3) der Leiterplatte (4) eingesteckt und durch die in den Rasterbohrungen (3) fixierten Anschlußelemente (6) an der Leiterplatte (4) festgehalten wird.

FIG 1

FIG 2

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y,D | DE-A-3 028 107 (SCHURTER) * Seite 5, Zeile 23 - Seite 7, Zeile 5 * | 1 | H 05 K 3/30 |
| Y | FR-A-1 232 356 (BONHOMME) * Figur 1 * | 1 | |
| A | FR-A-2 258 716 (GENERAL SIGNAL) | 1 | |
| A | DE-A-1 537 598 (CANNON) | 1 | |

| RECHERCHIERTE SACHGEBIETE (Int. Cl.4) |
|---|
| H 05 K 3/00 |
| H 05 K 7/00 |
| H 01 R 9/00 |
| H 01 R 13/00 |

Der vorliegende Recherchenbericht wurde für alle Patentansprüche erstellt

| Recherchenort DEN HAAG | Abschlußdatum der Recherche 08-05-1985 | Prüfer BERTIN M.H.J. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82